# EUROPEAN PATENT APPLICATION

(11) **EP 2 360 725 A2**
(43) Date of publication of application: **24.08.2011**
(21) Application number: 11153905.2
(22) Date of filing: 09.02.2011
(51) Int. Cl.: H01L 23/433, H01L 23/473

(54) **Heat dissipation system with a spray cooling device**

(30) Priority: 12.02.2010 TW 099104710
(71) Applicant: MicroBase Technology Corp., Taoyuan 333 (CN)
(72) Inventor: Wu, Ching-Ping, 333, Taoyuan (TW); Cheng, Kai-An, 333, Taoyuan (TW); Wu, Chun-Hsien, 333, Taoyuan (TW); Lin, Ju-Hong, 333, Taoyuan (TW); Liao, Chia-Chen, 333, Taoyuan (TW); Meng, Hsien, 333, Taoyuan (TW); Meng, Hsien-Chun, 333, Taoyuan (TW)
(74) Representative: Ruuskanen, Juha-Pekka

(57) **Abstract**

A heat dissipation system includes a cooling device (1), a condenser (2), a vapor conveying duct (3) and a cooling liquid conveying duct (4). The cooling device (1) includes a housing (11), and an orifice plate (12) dividing an inner space of the housing (11) into a liquid supply chamber (102) and an evaporation chamber (103), and formed with multiple micro orifices (120) each having a diameter ranging from 5 to 1000 micrometers. The condenser (2) includes a fluid inlet (201), a condensing chamber (202) and a fluid outlet 203). The vapor conveying duct (3) connects a vapor outlet (104) of the housing (11) and the fluid inlet (201) of the condenser (2). The cooling liquid conveying duct (4) connects a cooling liquid inlet (101) of the housing (11) and a fluid outlet (203) of the condenser (2).

## Description

The invention relates to a heat dissipation system, and more particularly to a closed-loop heat dissipation system that employs a principle of a liquid-vapor phase change.

An ordinary active-type heat-dissipating system for electronic components such as a fan incorporated with fins, a fan incorporated with fins and heat-transmitting ducts, etc., usually faces a problem of insufficient unit area heat flux and hence cannot meet the requirement for dissipating heat generated by high-powered electronic components.

To meet the requirement for dissipating heat generated by high-powered electronic components, in recent years, heat dissipation technique employing operating principles of liquid-vapor phase change have been developed. For example, a self-contained spray heat dissipation system is disclosed in U. S. Patent Number 7,082,778. This system operates based on a principle of an ink-jet technology using an ink injecting nozzle incorporating a heated electrode plate. A working fluid is drawn into a spray chamber through surface tension forces and is sprayed in the spray chamber. The sprayed liquid is vaporized when contacting the heated electronic components. During vaporization, part of the heat from the electronic components is absorbed by the vaporized liquid. However, the ink-jet nozzle not only has a complicated structure, but also requires an electrode plate that must be heated, resulting in an increased temperature of the working fluid and reducing an overall heat dissipation effect.

An object of the present invention is to provide a heat dissipation system with a simple construction and high heat dissipating efficiency.

Another object of this invention is to provide a cooling device that can efficiently spray a working fluid to assist vaporization.

Accordingly, a heat dissipation system for dissipating heat from a heat source according to the present invention, includes a cooling device, a condenser, a vapor conveying duct and a cooling liquid conveying duct. The cooling device includes a housing, and an orifice plate mounted in the housing. The orifice plate divides an inner space of the housing into a liquid supply chamber and an evaporation chamber proximate to the heat source, and has a plurality of micro orifices each having a diameter ranging from 5 to 1000 micrometers. The housing has a cooling liquid inlet communicated with the liquid supply chamber and adapted to permit a working fluid to flow into the liquid supply chamber, and a vapor outlet communicated with the evaporation chamber.

The condenser includes a fluid inlet, a condensing chamber and a fluid outlet. The vapor conveying duct is connected to the vapor outlet of the housing and the fluid inlet of the condenser. The cooling liquid conveying duct is connected to the cooling liquid inlet of the housing and the fluid outlet of the condenser. The cooling device, the condenser, the vapor conveying duct and the cooling liquid conveying duct cooperate to form a closed circuit.

Other features and advantages of the present invention will become apparent in the following detailed description of the preferred embodiments with reference to the accompanying drawings, of which:
Figure 1 is a block diagram illustrating the first preferred embodiment of a cooling system according to the present invention;
Figure 2 is an exploded perspective view of a cooling device of the first preferred embodiment;
Figure 3 is a schematic diagram illustrating a working fluid operating inside the cooling device of the first preferred embodiment;
Figure 4 is perspective view of an orifice plate of the first preferred embodiment;
Figures 5 and 6 are schematic diagrams illustrating manufacturing processes of the orifice plate;
Figure 7 is a schematic diagram illustrating a condenser of the first preferred embodiment;
Figures 8 and 9 are top views of the orifice plate used in the second preferred embodiment;
Figure 10 is a schematic diagram illustrating the orifice plate that indents downward at its central part during operation;
Figure 11 is a schematic diagram illustrating the cooling system applied to an LED lamp device; and
Figure 12 is a schematic diagram illustrating the cooling system applied to a computer housing.

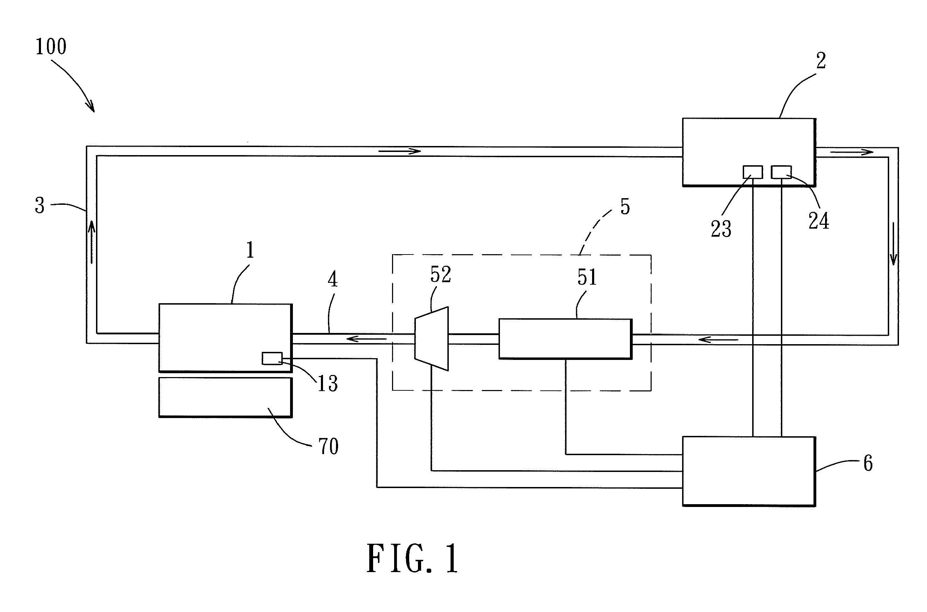

Referring to Figure 1, there is shown a cooling system 100 according to the first preferred embodiment of the present invention for dissipating heat generated by a heat source 70. The cooling system includes a cooling device 1, a condenser 2, a vapor conveying duct 3, a cooling liquid conveying duct 4, a fluid driving module 5 and a power and control module 6. The cooling device 1, the condenser 2, the vapor conveying duct 3 and the cooling liquid conveying duct 4 cooperate to form a closed circuit. The fluid driving module 5 has a pump 51 connected to the closed circuit for driving a working fluid, anda control valve 52 connected to the closed circuit for controlling the working fluid. In this embodiment, the working fluid is one of the Flourinert and Novec series products manufactured by 3M. However, the working fluid may also include water, other liquids. The pump 51 may be a piezoelectric thin film type, a gear type, or an electromagnetic type, and is compatible with the working fluid. If the pump 51 can be operated to control the liquid flow, then the control valve 52 can be dispensed with.

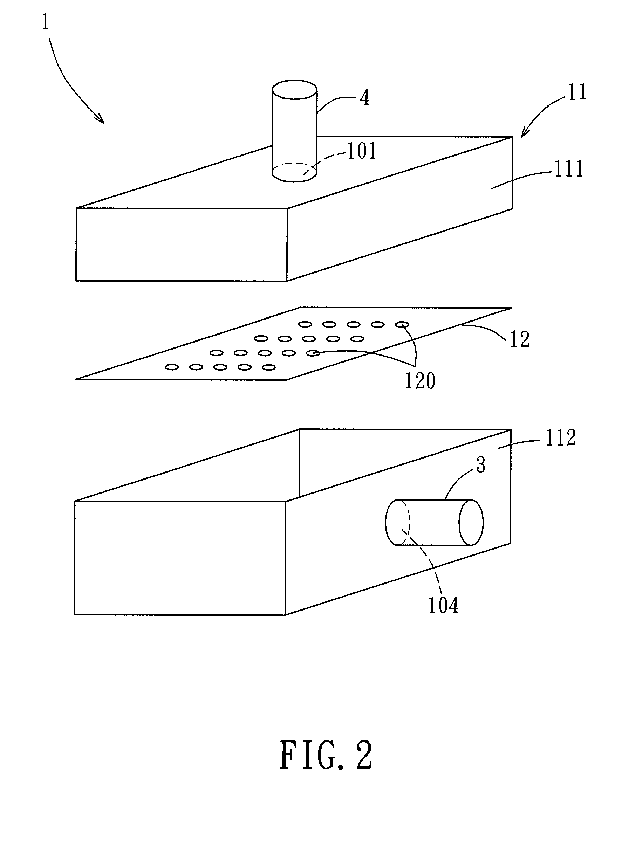

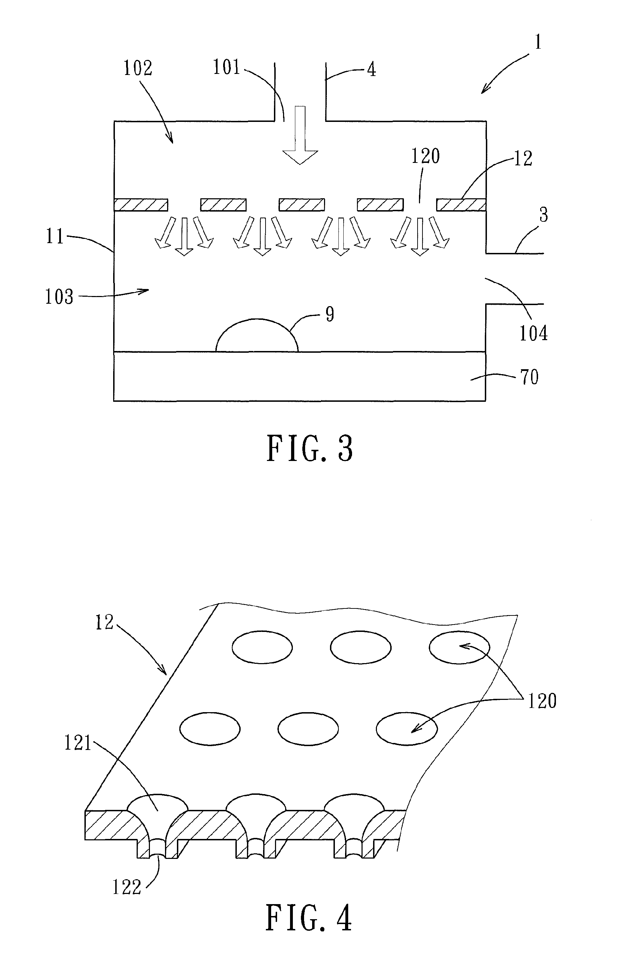

Referring again to Figures 2 and 3, the cooling device 1 includes a housing 11 having a bottom side contacting the heat source 70, an orifice plate 12 mounted in the housing 11 and a temperature sensing member 13. The orifice plate 12 divides an inner space of the housing 11 into an upper liquid supply chamber 102 and a lower evaporation chamber 103. The housing 11 has a cooling liquid inlet 101 communicated with the liquid supply chamber 102 and adapted to permit a working fluid to flow into the liquid supply chamber 102, and a vapor outlet 104 communicated with the evaporation chamber 103. The housing 11 has an upper housing part 111 def ining the liquid supply chamber 102 and a lower housing part 112 defining the evaporation chamber 103 and assembled to the upper housing part 111.

Referring to Figure 4, the orifice plate 12 has a thickness ranging from 20 to 300 micrometers and is formed with a plurality of micro orifices 120 arranged in a matrix layout or in intersecting rows. Each of the micro orifices 120 has a diameter ranging from 5 to 1000 micrometers. The micro orifices 120 are spaced apart from each other by a distance that ranges from 5 to 2000 micrometers. In this embodiment, the micro orifices 120 have a diameter ranging from 10 to 200 micrometers, preferably, from 5 to 500 micrometers, to provide an improved spraying effect that assists heat dissipation.

Referring again to Figures 4, 5 and 6, a manufacturing method of making the orifice plate 12 includes the following steps:

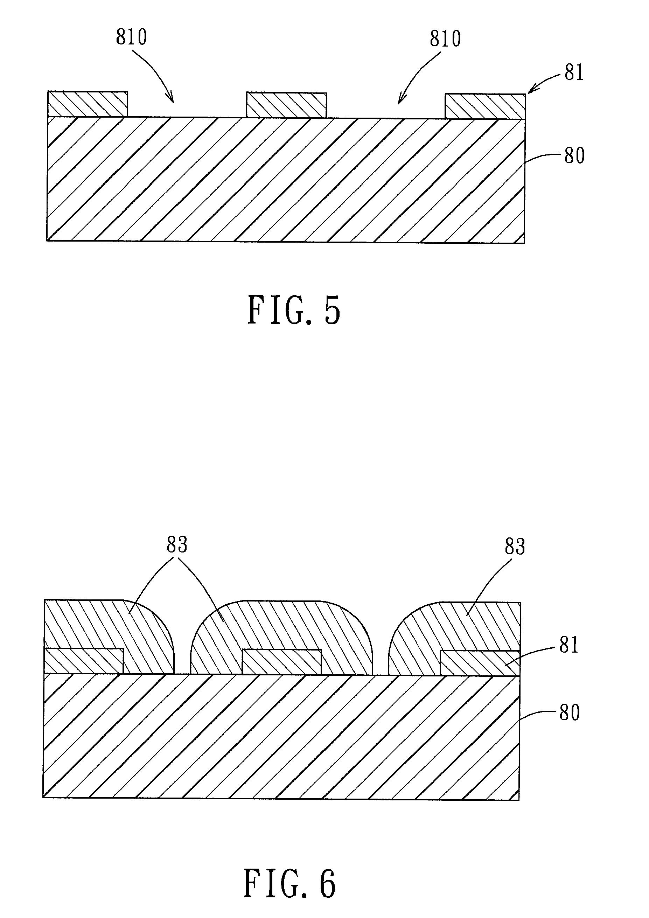

In the beginning, a surface of a substrate body 80, such as a glass substrate, is formed with a metal layer deposited (not shown in the Figure) by a technique, such as physical vapor deposition (abbreviated as PVD), or chemical vapor deposition (abbreviated as CVD). Next, a photoresist layer is formed by spin coating, or dip coating. The photoresist layer is exposed through a photomask by a photolithography technique, and is developed to remove the unexposed area of the photoresist layer and to thereby expose parts of the deposited metal layer to be removed. Thereafter, the exposed part of deposited metal layer uncovered by the photoresist layer is etched, and the remaining photoresist layer is removed. At this state, the deposited metal layer 81 formed on the substrate body 80 is provided with a plurality of holes 810, as shown in Figure 5, which are prefabricated holes for the micro orifices 120 of the orifice plate 12. The holes 810 are larger than the micro orifices 120.

Referring to Figure 6, after the holes 810 are formed in the metal layer 81, another metal layer 83 is formed on the surface of the deposit metal layer 81 by electro-forming in a mold (not shown). After the mold is removed, the metal layer 83 is separated from the substrate body 80 and the metal layer 81, and the orifice plate 12 as shown in Figure 4 is obtained.

The orifice plate 12 may also be made by other methods, such as electro-forming, laser processing, thermal pressure forming, injection molding, etc.

Referring back to Figures 2, 3 and 4, the orifice diameter of the micro orifices 120 of the orifice plate 12 can be adjusted by the using the aforementioned process. Each of the micro orifices 120 includes a liquid intaking end 121 proximate to the liquid supply chamber 102 and a liquid ejecting end 122 proximate to the evaporation chamber 103. The orifice diameter of each of the micro orifices 120 tapers from the liquid intaking end 121 to the liquid ejecting end 122.

When the working fluid flows into the liquid supply chamber 102 through the cooling liquid inlet 101, the working fluid is sprayed into the evaporation chamber 103 through the multiple micro orifices 120. The working fluid sprayed into the evaporation chamber 103 forms a thin sprayed layer on a bottom of the evaporation chamber 103 where the heat source 70 is disposed. The sprayed layer absorbs heat generated by the heat source 70 and is vaporized. Bubbles 9 are easily formed on the heat source 70 due to vaporization of the working fluid. The vapor from the heat source 70 exits from the housing 1 through the vapor outlet 104.

In this embodiment, because the lower housing part 112 has an inner surface formed with microstructure, the surface area thereof is increased, improving the effects of evaporating the working fluid and absorbing heat from the heat source 70.

Referring back to Figures 1 and 3, the vapor inside the evaporation chamber 103 flows into the vapor conveying duct 3 through the vapor outlet 104. In this embodiment, the vapor conveying duct 3 is made of a material compatible with the working fluid, such as a polymeric material, or stainless steel, and has an inner surface formed with microstructures in order to increase an overall heat transfer surface area and to facilitate condensation of the vapor inside the vapor conveying duct 3. By virtue of the pump 51, the vapor pressure and the capillary action of the vapor conveying duct 3, the vapor or the condensed liquid can be drawn into the condenser 2.

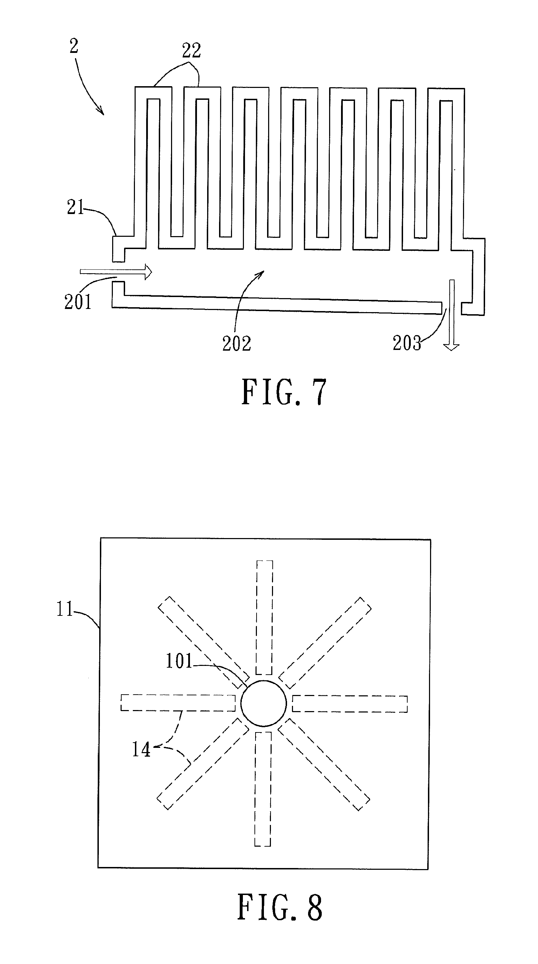

Referring to Figure 7, the condenser 2 includes a chamber casing 21 and a plurality of fins 22 in spatial communication with the chamber casing 21. The fins 22 are hollow, and have interior spaces communicated with an interior of the chamber casing 21 to form a condensing chamber 202. The chamber casing 21 has a fluid inlet201 in fluid communication with the condensing chamber 202 and a fluid outlet 203. In this embodiment, the hollow fins 22 are used for the purpose of increasing heat exchange area and enhancing the effect of condensing the vapor. Besides, the inner surfaces of the chamber casing 21 and the hollow fins 22 are formed with microstructures to increase the surface area and to enhance condensation effects. When the vapor enters from the fluid inlet 201 to the condensing chamber 202, a rapid heat exchange can be effected to reduce the temperature of the vapor and to condense the same.

Preferably, the chamber casing 21 has an inclined bottom side, the fluid outlet 203 is formed at a lower position of the bottom side, and the fluid inlet201 is arranged to be higher than the fluid outlet 203. With such a design, the cooling liquid is permitted to easily flow into the cooling liquid conveying duct 4. The cooling liquid conveying duct 4 is connected to the cooling liquid inlet 101 of the cooling device 1 and the fluid outlet 203 of the condenser 2.

Referring again to Figure 1, this embodiment utilizes the power and control module 6 for supplying power and controlling the fluid driving module 5. The condenser 2 further includes a temperature sensing member 23 for sensing the temperature of the condensing chamber 202 and a pressure sensing member 24 for sensing the pressure of the condensing chamber 202. The power source and control module 6 is connected to the temperature sensing member 23 and the pressure sensing member 24 of the condenser 2, and the temperature sensing member 13 of the cooling device 1. The sensed temperature and pressure are used as parameters for controlling the speed of the pump 51, the size of the opening of the control valve 52, and the switching frequency of the control valve 52. The pump 51 operates according to the control signals from the fluid driving module 5. The control valve 52 opens or closes according to the control signals.

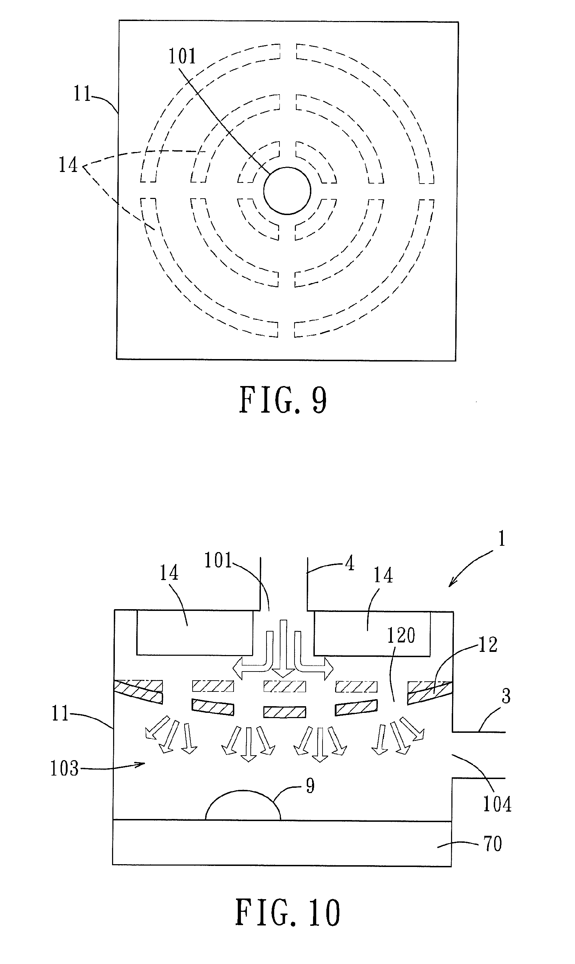

Referring back to Figures 1, 2 and further to Figures 8 to 10, the secondpreferred embodiment of this invention differs from the first preferred embodiment in that, the cooling device 1 further includes a plurality of liquid guiding plates 14 mounted on the inner surface of the upper housing part 111. In Fig. 8, the liquid guiding plates 14 have a center beneath the cooling liquid inlet 101 and extend radially. In Fig. 9, the liquid guiding plates 14 extend concentrically.

When the working fluid enters the housing 1 through the cooling liquid inlet 101, the working fluid is guided by the liquid guiding plates 14 to flow in the guided directions. As shown in Fig. 10, the orifice plate 12 indents downward slightly at its central part beneath the cooling liquid inlet 101 because the pressure of the working fluid is relatively high proximate to the cooling liquid inlet 101. The working fluid flowing through the orifice plate 12 can be sprayed homogeneously into the evaporation chamber 103.

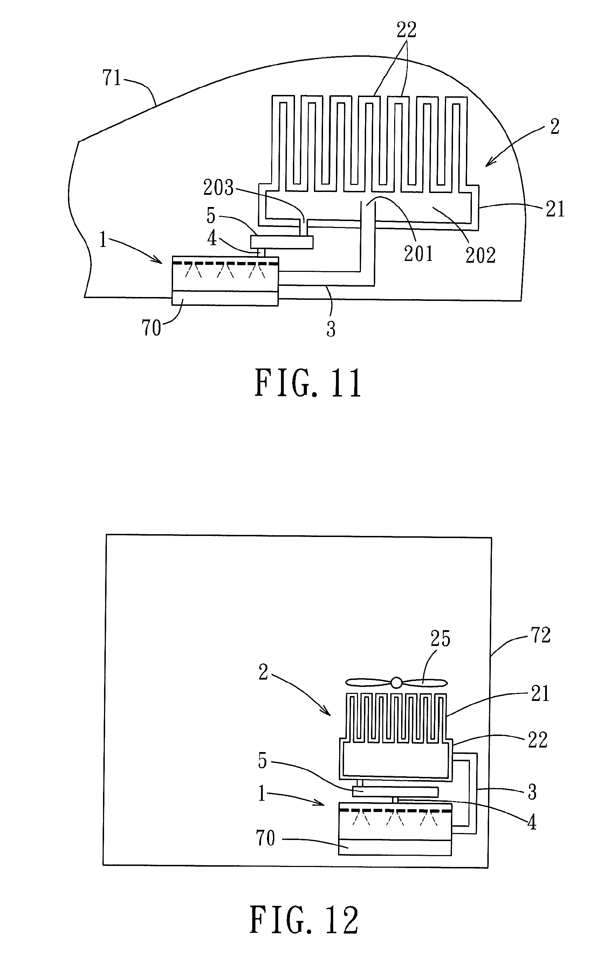

The cooling system 100 of this invention can be mounted to an LED lamp device 71 as shown in Figure 11. The cooling device 1 contacts the LED chip (functioning as the heat source 70) and absorbs heat therefrom through phase change. The cooling system 100 of this invention can also be mounted inside a computer housing 72 as shown in Figure 12. The cooling device 1 contacts the central processing unit (functioning as the heat source 70). To enhance counter flow and heat dissipation effect, the condenser 2 is provided with a fan 25 adjacent to the fins 22.

## Claims

1. A heat dissipation system for dissipating heat from a heat source (70), said heat dissipation system comprising:
a cooling device (1) including a housing (11), and an orifice plate (12) that divides an inner space of said housing (11) into a liquid supply chamber (102) and an evaporation chamber(103) proximate to the heat source (70), said housing (11) having a cooling liquid inlet (101) communicated with said liquid supply chamber (102) and adapted to permit a working fluid to f low into said liquid supply chamber (102), and a vapor outlet (104) communicated with said evaporation chamber(103), said orifice plate (12) having a plurality of micro orifices (120), each of which has a diameter ranging from 5 to 1000 micrometers;
a condenser (2) including a fluid inlet (201), a condensing chamber (202) and a fluid outlet (203);
a vapor conveying duct (3) connected to said vapor outlet (104) of said housing (11) and said fluid inlet (201) of said condenser (2); and
a cooling liquid conveying duct (4) connected to said cooling liquid inlet (101) of said housing (11) and said fluid outlet (203) of said condenser;
wherein said cooling device (1), said condenser (2), said vapor conveying duct (3) and said cooling liquid conveying duct (4) cooperate to form a closed circuit.

2. The heat dissipation system as claimed in Claim 1, wherein each of said micro orifices (120) of said orifice plate (12) has a liquid intaking end (121) and a liquid ejecting end (122) , each of said micro orifices (120) tapering from said liquid intaking end (121) to said liquid ejecting end (122).

3. The heat dissipation system as claimed in Claim 2, wherein said orifice plate (12) of said cooling device (1) is formed by electro-forming, laser processing, thermal pressure forming, or injection molding.

4. The heat dissipation system as claimed in any of Claims 1-3, wherein each of said micro orifices (120) has a diameter ranging from 5 to 500 micrometers, and/or said micro orifices (120) are spaced from each other by a distance that ranges from 5 to 2000 micrometers, and/or said orifice plate (12) has a thickness ranging from 20 to 300 micrometers.

5. The heat dissipation system as claimed in Claim 4, wherein each of said micro orifices (120) has a diameter ranging from 10 and 200 micrometers.

6. The heat dissipation system as claimed in any of Claims 1-5, wherein said housing (11) of said cooling device (1) has an upper housing part (11) defining said liquid supply chamber (102), and a lower housing part (112) defining said evaporation chamber(103) and assembled to said upper housing part (111).

7. The heat dissipation system as claimed in Claim 6, wherein said lower housing part (112) has an inner surface formed with microstructure for enhancing an evaporation effect.

8. The heat dissipation system as claimed in Claim 6 or 7, wherein said cooling device (1) further includes a plurality of flow guiding plates (14) mounted on an inner surface of said upper housing part (111).

9. The heat dissipation system as claimed in any of Claims 1-8, wherein said condenser (2) includes a chamber casing (21), and a plurality of fins (22) connected to said chamber casing (21).

10. The heat dissipation system as claimed in Claim 9, wherein each of said fins (21) is hollow and has an interior space communicated with an interior of said chamber casing (21), said chamber casing (21) and said fins (22) defining said condensing chamber (202).

11. The heat dissipation system as claimed in Claim 9-10, wherein said chamber casing (21) has an inclined bottom side, said fluid outlet (203) being formed at a lower part of said bottom side, said fluid inlet (201) being higher than said fluid outlet (203).

12. The heat dissipation system as claimed in any of Claim 9-11, wherein said chamber casing (21) and said fins (22) have inner surfaces formed with microstructures to enhance a condensation effect.

13. The heat dissipation system as claimed in Claim 1, wherein said vapor conveying duct (3) has an inner surface formed with microstructures that enhance a condensation effect.

14. The heat dissipation system as claimed in Claim 1, further comprising a fluid driving module (5) that includes a pump (52) connected to said closed circuit for drawing the working fluid.

15. The heat dissipation system as claimed in Claim 14, wherein said fluid driving module (5) further includes a control valve (51) inserted into said closed circuit for controlling the flow of the working fluid.

16. The heat dissipation system as claimed in Claim 15, further comprising a power and control module (6) for supplying power and controlling the operation of said closed circuit, and/or said cooling device (1) further includes a temperature sensing member (13) for sensing a temperature of the heat source (70), said power and control module (6) being connected to said temperature sensing member (13) and controlling said fluid driving module (5) based on the temperature sensed by said temperature sensing member (13).

17. A cooling device (1) included in a heat dissipation system as claimed in any of Claims 1-16, comprising: a housing (11), and an orifice plate (12) dividing an inner space of said housing (11) into a liquid supply chamber (102) and an evaporation chamber(103) proximate to a heat source (70), said housing (11) having a cooling liquid inlet (101) communicated with said liquid supply chamber (102) and adapted to permit a working fluid to flow into said liquid supply chamber (102), and a vapor outlet (104) communicated with said evaporation chamber(103), said orifice plate (12) having a plurality of micro orifices (120), each of which has a diameter ranging from 5 to 1000 micrometers.
